# EUROPEAN PATENT SPECIFICATION

(11) **EP 1 102 409 B1**
(45) Date of publication and mention of the grant of the patent: **04.10.2006**
(21) Application number: 99850172.0
(22) Date of filing: 18.11.1999
(51) Int. Cl.: H04B 1/04, H04L 27/04, H04L 27/20, H04L 27/26, H03F 3/217

(54) **Method and apparatus for generating a RF signal**
Verfahren und Vorrichtung zum Erzeugen eines hochfrequenten Sendesignals
Méthode et appareil pour générer un signal radiofréquence

(43) Date of publication of application: 23.05.2001
(73) Proprietor: TELEFONAKTIEBOLAGET LM ERICSSON (publ), 164 83 Stockholm (SE)
(72) Inventor: Hellberg, Richard, 14147 Huddinge (SE); Fonden, Tony, 16371 Spanga (SE); Dalipi, Spendim, 19142 Sollentuna (SV)
(74) Representative: Sandström, Staffan Sven

(56) References cited:
- EP-A- 0 426 560
- WO-A-98/11683
- US-A- 5 450 444

## Description

### TECHNICAL FIELD

The invention is concerned with a method and apparatus of generating a modulated RF signal. It is especially concerned with methods and apparatuses for modulation and amplification of a low- or medium-frequency information signal to a high-power radio frequency signal.

### BACKGROUND ART

In a radio base station, there is a need for a high-power amplifier in the transmitter section to provide each radio channel with enough power to reach the outer limits of the cell which the base station is covering.

Traditionally there has been a trade-off between efficiency and linearity in radio frequency (RF) power amplifiers. E.g. amplifiers of C-type are high efficient but has an insufficient linearity, while e.g. A-type amplifiers are very linear but are low-efficient.

The development in radio communication during the recent years has, however, created an increased need for linear high-power RF amplifiers. One reason for this is the increased use of modulation schemes with time-dependent envelope, like QAM (Quadrature Amplitude Modulation), OFDM (orthogonal frequency division modulation), and CDMA (Code Division Multiple Access). Another reason is the trend towards multi-carrier radio (MCR).

When the same amplifier is used for simultaneous amplification of several information signals modulated on different carrier waves or when linear modulation is used, such as QAM, high linearity is required, because in this case it is essential that all phase and amplitude positions of the signal components involved are maintained in the amplification, because if many carriers are amplified in a single amplifier, the envelope of the total signal will be time-dependent even if the individual signals are not. If linearity is not achieved, inter-modulation between the signal components might occur or the spectrum of the amplified signal sum might broaden, with the risk of interference with signals on other channels.

It has therefore been particularly problematic to find solutions for e.g. MCR base stations maintaining high efficiency due to the very stringent linearity requirements at the same time as high power is needed. Also the relatively large bandwidth makes a solution for this case particularly difficult.

The Swedish patent 507 373 of the applicant presents a method for generating a moderately wide-band (i.e. including a MCR signal) high-power RF signal with high efficiency and linearity. In this method, a sigma-delta modulator is used to generate a digital signal from an information signal followed by up-mixing and subsequent switching and band-pass filtering. The sigma-delta modulation transforms the analog (or very multi-level digital) signal to a signal containing only M (preferably, but not necessarily, equally spaced) levels by a quantization process. The so called quantization noise generated in this process is then rejected by a band-pass filter. The amplification is provided by the switching process. It works so that the input of the band-pass filter is connected to M different constant electrical potentials via M switches. At a given time, one and only one switch is closed, and all the others opened. The digital control signal (the digitally up-mixed sigma-delta coded base-band signal) determines which switch is closed.

If ideal switches (and an ideal band-pass filter) are used, the amplifier will have 100% efficiency and linearity. Real switches are however not ideal and therefore they will dissipate power and 100% efficiency is not obtained. Power will be dissipated due to voltage-drop across the closed switch and leakage-current through the opened switch.

Furthermore, the switches have a finite transition time between the closed and opened states. This will lead to the problem of switching transients. If, during some period of time during the switching transient, two switches are simultaneously in a low impedance state, then an almost short-circuited power supply has appeared.

If, on the other hand, during a switching transient, all switches are simultaneously in a high-impedance state, then a voltage transient will be created by the band-pass filter. The band-pass filter must have a high input impedance for out-of-band signals. For this reason it can be considered as a constant current generator during the short interval of time of a switching transient. This constant current passes the high-impedance switches, creating a high-voltage transient. This dissipates transient power, may create nonlinearities, and even degrade the life-time of the switches. It will also be more difficult to get the required selectivity from the band-pass filter since it will see a time-varying impedance.

To reduce the transient problems, one could try to use a faster switch. However, there is often a trade-off between speed, the conductivity of the closed switch (for a given minimum "off-resistance" in the opened state), and the required control-signal power. Thus, small transient losses may imply, e.g., higher ohmic losses in the steady-state "closed" state (or higher control-signal power).

Additional related art is disclosed in EP 0 426 560 and in US 5 450 444. EP 0 426 560 relates to digital modulation using in-phase and quadrature components, comprising a GMSK generator whose phase and quadrature outputs are forwarded to a channel comprising a SIGMA DELTA generator and to a modulator receiving the carrier with half the frequency of the frequency of the output bits from the SIGMA DELTA converter. US 5 450 444 discloses a digital AM transmitter, in which a carrier wave signal is divided into digital bits in a carrier wave divider and each separated bit is switched, amplified and combined into an AM wave signal. However, none of these documents solves the switching transient problem.

The object of the invention is to overcome the transient problems when a high-power RF signal is generated by means of quantization and switching.

### SUMMARY OF THE INVENTION

The method of the invention of generating a high-power modulated radio-frequency signal from a low- or medium frequency information signal is carried out by pulse-forming of the information signal by means of a quantifier

to form a digital signal having discrete signal values, generating one or more carrier waves of radio frequency, amplification by means of an amplifier comprising switches into a switched radio-frequency signal carrying the information, the switching events being controlled by the information content of the digital signal, and achieving the desired signal by means of a filter. The method is characterized in that in that the amplification is performed by connecting he switches (SM) to their respective alternating carrier voltages generated in step b) in accordance with the information content of the digital signal by closing a given switch at a given information content of the digital signal, only one switch closed at a time, the instants in time for the switching events chosen to coincide with the moment at which the carrier wave is zero or close to zero to avoid energy losses during the switching transients, thus causing mixing of the digital signal with a corresponding carrier wave.

The apparatus of the invention for generating a high-power modulated radio-frequency signal, comprises a quantifier for pulse-forming of an information signal to form a digital signal having discrete signal values, a radio-frequency carrier wave generator, an amplification unit comprising switches for achieving a switched radio-frequency signal carrying the information, the switches being controlled by the information content of the digital signal, and a filter for achieving the desired signal. The apparatus is characterized in that, the switches (SM) are connected to their respective alternating radio-frequency carrier voltages generated by said radio-frequency carrier wave generators to cause mixing of the digital signals (S_{M}) with a corresponding carrier wave in accordance with the information content of the digital signal (S_{M}) by a closing a given switch (SM) at a given information content of the digital signal, only one switch closed at a time, the instants in time for the switching events chosen to coincide with the moment at which the carrier wave is zero or close to zero to avoid energy losses during the switching transients.

The base-band signal (low- or medium frequency signal) can be analog or digital, simple or quadrature shifted into two signal components.

The switching transient problem is solved in the invention by connecting the switches to alternating "carrier" voltages instead of to constant ("DC") voltages as in the mentioned Swedish patent. The solution of the invention also lowers the switching frequency facilitating lower power for the control of the switches.

The variation of the carrier voltage can have different forms. If the carrier voltage is sinusoidal and varies between a top + level and a bottom minus level, the carrier voltage has a zero crossing at regular intervals in time (i.e. it has momentarily the value zero volts). If the instants in time for the switching are chosen to coincide with the zero crossings, no switching-transient problems exist as is explained in the following.

Assuming a switching event in an apparatus of the invention with two switches, where one of the switches is closed and the other open. If the switching is performed so that the second switch is closed slightly before the first switch is opened, both switches are momentarily closed at the transient moment. In the invention, this will not short-circuit the "power supply" (represented by the carrier generator in the invention), since the timing for the switching event has been chosen to coincide with the zero-crossing of the carrier voltage, at which moment there is no power supply. In such a switching strategy, the band-pass filter will at all times be connected to a low impedance (one or both switches are closed).

In addition to solving the switching-transient problem, the invention also normally gives a lower switching-frequency (i.e. the time interval between sucessive switching events is longer). In the sigma-delta based RF amplifier of prior art, the switching frequency is typically equal to twice the "carrier" frequency. In the invention, it is equal to the output sampling frequency of the quantifier, (i.e. twice the base-band-width times the oversampling ratio, plus some guard interval), since in the invention the mixing of the carrier wave and the information signal (the coded base band signal) takes place at the switching event.

Switches dissipate control-signal power. A bistable switch dissipates control signal power only when changing from one state to the other (closed to opened, opened to closed). For a quasi-bistable switch, this is the case to a good approximation. Thus, if bistable or quasi-bistable switches are used, the required control signal power is proportional to the switching frequency. Because of the lower switching-frequency of the apparatus of the invention (equal to the output sampling frequency of the quantizer), it thus requires less power for the control of the switches, and give a higher efficiency amplifier.

The invention is of benefit in all kinds of transmitters where the signal has a time-dependent envelope. This includes in particular radio base stations using the MCR concept, but also handsets for various standards, wireless local area (WLAN) modems, etc.

In the following an example of the invention is described by means of two figures. The intention is not to restrict the invention to the details of these embodiments, the scope of which invention is defined by the claims.

### BRIEF DESCRIPTION OF DRAWINGS

Figure 1 is a schematic view of the general principle of the invention.
Figure 2 is a more detailed example of the invention.

### DETAILED DESCRIPTION

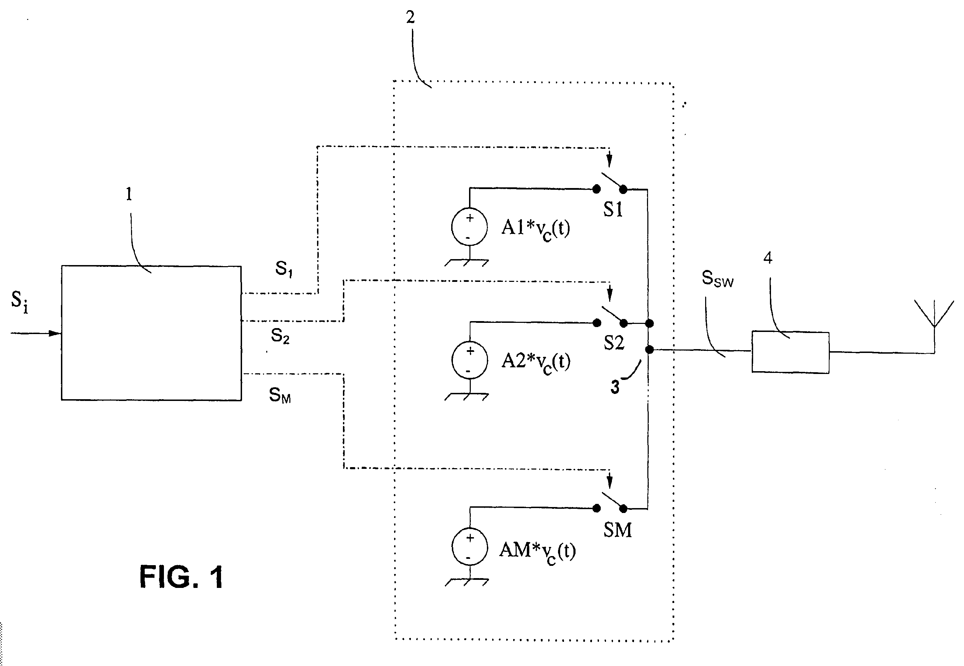

In the embodiment of figure 1, an incoming low-frequency or medium-frequency (base-band) information signal Sᵢ is quantified in a quantifier 1 to generate a digital signal with M discrete signal values S_{M} (i.e. S₁, S₂, S₃ etc.). The digital signal represents a version of the information signal which is sampled fₛ (sample frequency) times per second. The values of the digital signal comprise one or more bits and have thus two or more signal values.

The quantifier 1 is for example a sigma-delta modulator, the principle of which is explained in SE patent 507 373. A thorough introduction to the sigma-delta modulator can be found in Norsworthy, S.R., Schreier, R., Temes, GC. (eds); 1997; "Delta-Sigma data converters - theory, design, and Simulation", IEEE Press (ISBN 0-7803-1045-4).

The basic principle of the sigma-delta modulator is that, to the input, there is lead a low-rate sample stream of the information signal (which is analog or it is digital with a large number of quantization levels, i.e. where each sample has a large number of bits). At the output, there is a smaller number of bits and a higher sampling frequency. The number of bits at the output is often the lowest possible, i.e. M = 2 (one bit), in which case, there are only two quantization levels, e.g. -1 and +1. The reduction of the number of bits in the sample stream will cause distortion. The distortion can be approximated as "noise", so called quantization noise, which is not forwarded to the antenna at the end.

The digital signal SM is lead to a given switch S1, S2.... or SM of a switching unit 2, in accordance with the value of the signal. A given value of the digital signal S_{M} corresponds to a given switch to be closed. Different coding methods can be used to express the value of M. In one method, switch S1 is chosen, when the value M of the digital signal S_{M} is 1, and so on. A switched signal Ssw is achieved from the digital signal S_{M} so that the M switches are regulated in accordance with the information content in the digital signal, S_{M}, a given information content resulting in a given switch to be closed. One and only one switch at a time is closed (except possibly for a short period of time during a switching transient when two switches might simultaneously be closed).

The power of the switched signals depends on the time-dependence of the carrier wave voltage and an (amplitude) amplification is achieved when a given information content is given a certain carrier wave of a given amplitude.

The switching unit 2 thus performs both mixing and amplification of the S_{M} signal. All switches S1 - SM are connected to their respective carrier generators and to a common output 3. The carrier amplitudes are denoted by A1, A2,...AM, and its generic time-dependence by v_{c}(t), the carrier wave voltage being a function of the time. The carrier wave functions can thus have the forms A1*v_{c}(t), A2*v_{c}(t), ...AM*v_{c}(t). When a given switch is closed, its carrier wave becomes available resulting in an amplified information signal of a given value. The control signal (information signal) has to be handled so that there are never two switches simultaneously open.

In the simplest case v_{c} is sinusoidal (v_{c} (t) = cos (2πf_{carrier}t)). The values of the amplitudes should coincide with the output levels of the sigma-delta modulator. If the sigma-delta modulator outputs N, then switch number SN should be closed and all the others opened, and so on.

The switching unit 2 thus converts the digital signal to a switched radio-frequency (RF) signal S_{sw} carrying the information and from which a desired part can be taken by filtering.

The generation of the carrier waves of radio-frequency is made in accordance with known methods. The easiest way is to generate a sinusoidal carrier. The generation of a non-sinusoidal carrier is more complex, but has that advantage it is possible to choose the carrier to stay close to zero for some finite time-interval around the switching events.

The switching event can always be chosen to take place at a zero-crossing, if the carrier frequency is a multiple of the output sampling frequency of the quantifier (e.g. a sigma-delta modulator), even if the carrier voltage is not sinusoidal. It is possible to choose the frequencies (the harmonic and subharmonic contents) of a non-sinusoidal carrier so that it stays close to zero for some time-interval around the switching events.

If the carrier wave is sinusoidal, the modulated digital signal will be transposed so that a base-band frequency component of Fb will end up at Fc-Fb and Fc+Fb, where Fc is the carrier frequency. A band-pass filter 4 is placed after the switches that rejects the unwanted one of these side bands (either Fc-Fb or Fc+Fb for all Fb-s in the base band). The band-pass filter 4 also rejects the (frequency transponed) quantization noise from the quantifier.

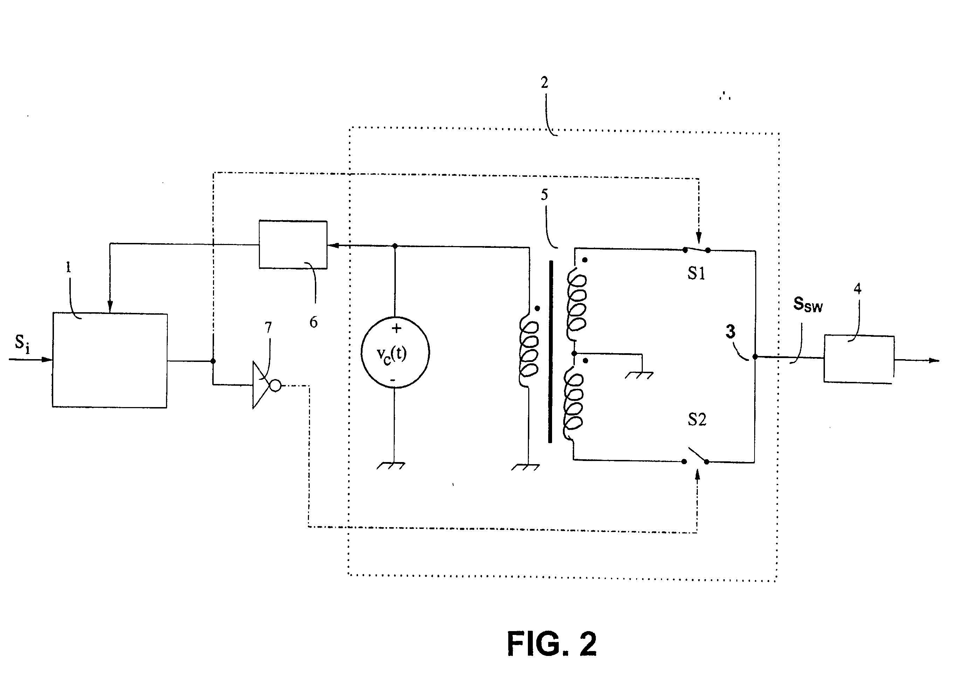

Figure 2 shows explicitly a possible implementation of a two-level system (M=2). This implementation uses a (supposedly ideal) transformer 5 to generate the two amplitudes of the carrier signal. The switch S1 is thus connected to an electric potential with respect to the ground of v_{c}(t) while S2 is connected to -v_{c}(t). Thus, when switch S1 is closed and S2 opened, the input of the band-pass filter 4 is connected to +v_{c}(t), and to -v_{c}(t) when S2 is closed and S1 open. When the sigma-delta modulator outputs +1, switch S1 is closed and S2 opened and vice versa when it outputs -1. The frequency divider 6 is a control unit for adjusting the frequencies and the inverter 7 regulates the switches in accordance with the values +1 or -1. The other reference numbers 1, 2, 3 and 4 are equal to those used in figure 1.

In an other embodiment of the invention, not illustrated, instead of rejecting the unwanted side-bands by the band-pass filter, one could alternatively use a cancellation arrangement based on quadrature signals. In this case, two modulated base-band signals are used, identical as to a 90 degrees phase-difference. These two signals control the switches in two different mixers. The mixers are fed with carriers of 90 degrees phase difference. The signals from the mixers are added either before or after the band-pass filters. Also in this arrangement, the (frequency transposed) quantization noise from the sigma-delta modulator is rejected by the band-pass filter(s).
A slightly different variant of this alternative would be to neither reject or to cancel either of the side-bands, but to use them as two linearly independent channels, and to use them as in the traditional quadrature phase I and Q arrangement. Also in this arrangement, the frequency transponed quantisation noise from the modulator is rejected by the band-pass filter(s).

If the carrier is not sinusoidal and contains more than one frequency component, replica of the modulated base-band signal will fall onto the band-pass filter's passband. However, if all the frequency components of the carrier are integer multiples of the sampling frequency of the quantifier, all these components will be aligned so that a particular base-band frequency component will be mapped onto the same RF frequency for all the replica. The occurance of a non-harmonic carrier will therefore not create any distortion in the resulting RF signal. The carrier may contain both harmonics and subharmonics of its fundamental frequency as long as all of them are integer multiples of the sigma-delta output sampling frequency.

While any number M of equidistant or non-equidistant "carrier" amplitudes might be used, the most practical arrangement would probably be to use only two levels (as in the embodiment of figure 2) or three levels.

A well-known fact of sigma-delta modulators is that a two-level system is less sensitive to mismatches in the components. Thus, an amplitude error, e.g. in one or both of the two carrier amplitudes switched between, does not introduce any distortion. in a three- or many level system, however, distortion is created by a deviation from its normal value in one of the carrier amplitudes switched between.

## Claims

1. Method of generating a high-power modulated radio-frequency signal from a low- or medium frequency information signal (Sᵢ) by
a) Pulse-forming of the information signal by means of a quantifier (1) to form a digital signal (S_{M}) having discrete signal values (M),
b) generating two or more carrier waves of radio frequency by means of alternating radio-frequency signals,
c) amplification by means of a switching unit (2) comprising two or more switches (SM) into a switched radio-frequency signal (S_{SW}) carrying the information, the switching events being controlled by the information content of the digital signal,
d) achieving the desired signal by means of a filter (4),
**characterized in that** the amplification is performed by connecting the switches (SM) to their respective alternating carrier signals generated in step b) in accordance with the information content of the digital signal by closing a given switch at a given information content of the digital signal, only one switch closed at a time, the instants in time for the switching events chosen to coincide with the moment at which the carrier wave is zero or close to zero to avoid energy losses during the switching transients, thus causing mixing of the digital signal with a corresponding carrier wave.

2. Method of claim 1, **characterized in that** the alternation of the carrier signals is performed so that the frequency/frequencies of the carrier waves generated is/are a multiple/multiples of the output sampling frequency of the quantifier.

3. Method of claim 1 or 2, **characterized in that** the alternation of the carrier signals is performed so that the resulting carrier wave is a sinusoidal signal.

4. Method of claim 3, **characterized in that** the filter (4) is a band-pass filter rejecting distortion caused by the amplification and the unwanted side band of the signal from step c).

5. Method of any of claims 1 - 4, **characterized in that** the switching frequency is equal to the output sampling frequency of the quantifier (1)

6. Method of claim 1 or 2, **characterized in that** the carrier signal is non-sinusoidal in such a way that it is a sum of frequency components, where all the components have frequencies that are integers of the output sampling frequency of the quantifier.

7. Method of claim 6, **characterized in that** the carrier signals are chosen so that they stay close to zero for the time-interval around the switching events.

8. Method of claim 1 or 2, **characterized in that** the information signal is quadrature shifted in two components, whereby two digital signals are formed in step a) controlling the switches in two different amplifier/mixers of the invention, which are fed with carriers of 90 degrees phase-difference.

9. Method of claim 1 or 2, **characterized in that** the side-bands are used as two linearly independent channels as in the quadrature phase I and Q arrangement of claim 9.

10. Method of claim 7 or 8, **characterized in that** when one band-pass filter is used, the signals formed in step b) are added before the filter.

11. Method of claim 7 or 8, **characterized in that** when two band-pass filters are used the signals are added after the band-pass filters.

12. Method of any of claims 8 - 11, **characterized in that** the filter(s) is/are (a) band-pass filter(s) rejecting distortion caused by the amplification.

13. Method of any of claims 1 - 12, **characterized in that** in step a) there is formed a digital signal (S_{M}) with two signal values.

14. Apparatus for generating a high-power modulated radio-frequency signal, comprising
a quantifier (1) for pulse-forming of an information signal (Sᵢ) to form a digital signal (S_{M}) having discrete signal values (M),
one or more radio-frequency carrier wave generators (A_{M}),
a switching unit (2) comprising two or more switches (SM) for achieving an amplified and switched radio-frequency signal (S_{SW}) carrying the information, the switches being controlled by the information content of the digital signal,
a filter (4) for achieving the desired signal,
**characterized in that** the switches (SM) are connected to their respective radio-frequency carrier wave generators to cause mixing of the digital signals (S_{M}) with a corresponding carrier wave in accordance with the information content of the digital signal (S_{M}) by a closing a given switch (SM) at a given information content of the digital signal, only one switch closed at a time, the instants in time for the switching events chosen to coincide with the moment at which the carrier wave is zero or close to zero to avoid energy losses during the switching transients,

15. Apparatus of claim 14, **characterized in that** the quantifier (1) is a sigma-delta modulator.

16. Apparatus of claim 14 or 15, **characterized in that** the filter (4) is a band-pass filter rejecting unwanted signals and distortion caused by the amplification.

17. Apparatus of any of claim 14 - 16, **characterized in that** the carrier wave generator is a transformer (5) generating carrier waves of two different amplitudes.

## Patentansprüche

1. Verfahren zum Erzeugen eines hochleistungsfähigen modulierten hochfrequenten Sendesignals aus einem Informationssignal (Sᵢ) mit Nieder- oder Mittelfrequenz durch
a) Impulsbildung des Informationssignals mittels eines Quantifikators (1) zum Bilden eines digitalen Signals (S_{M}), das unterschiedliche Signalwerte (M) aufweist,
b) Erzeugung von zwei oder mehr Trägerwellen mit Hochfrequenz mittels alternierender hochfrequenter Sendesignale,
c) Verstärkung mittels einer Schalteinheit (2), die zwei oder mehr Schaltungen (SM) umfasst, in ein geschaltetes hochfrequentes Sendesignal (S_{SW}), das die Informationen trägt, wobei das Schaltereignis durch den Informationsinhalt des digitalen Signals gesteuert wird,
d) Erzielung des gewünschten Signals mittels eines Filters (4), **dadurch gekennzeichnet, dass** die Verstärkung durch Verbinden der Schaltungen (SM) mit ihren jeweiligen alternierenden Trägersignale durchgeführt wird, die in Schritt b) gemäß dem Informationsinhalt des digitalsten Signals erzeugt werden, indem eine bestimmte Schaltung bei einem bestimmten Informationsinhalt des digitalen Signals, jeweils nur eine Schaltung zu einer bestimmten Zeit, geschlossen wird, wobei die Instanzen der Zeit für die Schaltereignisse so gewählt werden, dass sie mit dem Zeitpunkt zusammenfallen, zu dem die Trägerwelle Null der nahe Null ist, um Energieverluste während der Einschaltstöße zu vermeiden, wodurch das Mischen des digitalen Signals mit einer entsprechenden Trägerwelle veranlasst wird.

2. Verfahren nach Anspruch 1, **dadurch gekennzeichnet, dass** das Alternieren der Trägersignale so durchgeführt wird, dass die Frequenz(en) der erzeugten Trägerwellen ein Vielfaches (Vielfache) der ausgegebenen Abtastfrequenz des Quantifikators ist (sind).

3. Verfahren nach Anspruch 1 oder 2, **dadurch gekennzeichnet, dass** das Alternieren des Trägersignals so durchgeführt wird, dass die daraus resultierende Trägerwelle ein sinusförmiges Signal ist.

4. Verfahren nach Anspruch 3, **dadurch gekennzeichnet, dass** der Filter (4) ein Bandpassfilter ist, der Verzerrung, die durch die Verstärkung verursacht wurde, und das ungewollte Seitenband des Signals aus Schritt c) zurückweist.

5. Verfahren nach Anspruch 1 bis 4, **dadurch gekennzeichnet, dass** die Schaltfrequenz gleich der ausgegebenen Abtastfrequenz des Quantifikators (1) ist.

6. Verfahren nach Anspruch 1 oder 2, **dadurch gekennzeichnet, dass** das Trägersignal auf eine Art nicht sinusförmig ist, dass es eine Summe der Frequenzkomponenten ist, wobei alle Komponenten Frequenzen haben, die Ganzzahlen der ausgegebenen Abtastfrequenz des Quantifikators sind.

7. Verfahren nach Anspruch 6, **dadurch gekennzeichnet, dass** die Trägersignale so gewählt werden, dass sie für das Zeitintervall um die Schaltereignisse herum nahe Null bleiben.

8. Verfahren nach Anspruch 1 oder 2, **dadurch gekennzeichnet, dass** das Informationssignal in zwei Komponenten Quadratur-phasenverschoben wird, wobei in Schritt a) zwei digitale Signale ausgebildet werden, die die Schaltungen in zwei verschiedenen Verstärkern/Mischern der Erfindung steuern, die mit Trägern von 90 Grad Phasendifferenz gespeist werden.

9. Verfahren nach Anspruch 1 oder 2, **dadurch gekennzeichnet, dass** die Seitenbänder als zwei linear unabhängige Kanäle wie in der Anordnung der Quadraturphase I und Q nach Anspruch 9 verwendet werden.

10. Verfahren nach Anspruch 7 oder 8, **dadurch gekennzeichnet, dass** wenn ein Bandpassfilter verwendet wird, die Signale, die in Schritt b) ausgebildet werden, vor dem Filter addiert werden.

11. Verfahren nach Anspruch 7 oder 8, **dadurch gekennzeichnet, dass** wenn zwei Bandpassfilter verwendet werden, die Signale nach den Bandpassfiltern addiert werden.

12. Verfahren nach Anspruch 8 bis 11, **dadurch gekennzeichnet, dass** der (die) Filter (ein) Bandpassfilter ist (sind), der (die) Verzerrung zurückweist (zurückweisen), die durch die Verstärkung hervorgerufen wird.

13. Verfahren nach Anspruch 1 bis 12, **dadurch gekennzeichnet, dass** in Schritt a) ein digitales Signal (S_{M}) mit zwei Signalwerten ausgebildet wird.

14. Vorrichtung zum Erzeugen eines hochleistungsfähigen modulierten hochfrequenten Sendesignals, umfassend
einen Quantifikator (1) zum Impulsbilden eines Informationssignals (Sᵢ) zum Ausbilden eines digitalen Signals (S_{M}), das unterschiedliche Signalwerte (M) aufweist,
einen oder mehr Erzeuger (AM) für hochfrequente Trägerwellen,
eine Schalteinheit (2), die zwei oder mehr Schaltungen (SM) zum Erzielen eines hochfrequenten Sendesignals (S_{SW}), das die Informationen trägt, umfasst, wobei die Schaltungen durch den Informationsinhalt des digitalen Signals gesteuert werden,
einen Filter (4) zum Erzielen des gewünschten Signals,
**dadurch gekennzeichnet, dass** Schaltungen (SM) mit ihren hochfrequenten Trägerwellenerzeugern verbunden sind, UM das Mischen des digitalen Signals (S_{M}) mit einer entsprechenden Trägerwelle gemäß dem Informationsinhalt des digitalen Signals (S_{M}) hervorzurufen, indem eine bestimmte Schaltung (SM) bei einem bestimmten Informationsinhalt des digitalen Signals geschlossen wird, jeweils nur eins zu einem Zeitpunkt, wobei die Instanzen der Zeit für die Schaltereignisse so gewählt werden, dass sie mit dem Zeitpunkt zusammenfallen, zu dem die Trägerwelle Null oder nahe Null ist, um Energieverluste während der Einschaltstöße zu vermeiden.

15. Vorrichtung nach Anspruch 14, **dadurch gekennzeichnet, dass** der Quantifikator (1) ein Sigma-Delta-Modulator ist.

16. Vorrichtung nach Anspruch 14 oder 15, **dadurch** gekenzeichnet, dass der Filter (4) ein Bandpassfilter ist, der ungewollte Signale und Verzerrung, die durch die Verstärkung verursacht wird, zurückweist.

17. Vorrichtung nach Anspruch 14 bis 16, **dadurch gekennzeichnet, dass** der Trägerwellenerzeuger ein Wandler (5) ist, der Trägerwellen mit zwei verschiedenen Amplituden erzeugt.

## Revendications

1. Procédé destiné à produire un signal radio fréquence modulé de forte puissance à partir d'un signal (Sᵢ) d'information de fréquence basse ou moyenne par
a) une formation par impulsion du signal d'information au moyen d'un quantificateur (1) pour former un signal (S_{M}) numérique ayant des valeurs (M) de signal discrètes,
b) une production de deux ou plus ondes porteuses de fréquence radio au moyen de signaux radiofréquence alternatifs,
c) une amplification au moyen d'un module (2) de commutation comportant deux ou plus de deux commutateurs (SM) en un signal (S_{SW}) radiofréquence commuté transportant l'information, les événements de commutation étant commandés par le contenu d'information du signal numérique,
d) une obtention du signal désiré au moyen d'un filtre (4),
**caractérisé en ce que** l'amplification est effectuée en raccordant les commutateurs (SM) à leurs signaux de porteuse alternative respectifs produits dans l'étape b) conformément au contenu d'information du signal numérique en fermant un commutateur donné à un contenu d'information donné du signal numérique, uniquement un commutateur étant fermé à la fois, les instants dans le temps pour les événements de commutation étant choisis pour coïncider avec le moment où l'onde porteuse est nulle ou proche de zéro afin d'éviter des pertes d'énergie pendant les transitoires de commutation, provoquant ainsi un mélange du signal numérique avec une onde porteuse correspondante.

2. Procédé selon la revendication 1 **caractérisé en ce que** l'alternance des signaux de porteuse est effectuée de sorte que la fréquence/les fréquences des ondes porteuses produites est/sont un multiple/des multiples de la fréquence d'échantillonnage de sortie du quantificateur.

3. Procédé selon la revendication 1 ou 2 **caractérisé en ce que** l'alternance des signaux de porteuse est effectuée de sorte que l'onde porteuse résultante est un signal sinusoïdal.

4. Procédé selon la revendication 3 **caractérisé en ce que** le filtre (4) est un filtre passe-bande rejetant une distorsion provoquée par l'amplification ainsi que la bande latérale non désirée du signal en provenance de l'étape c).

5. Procédé selon l'une quelconque des revendications 1 à 4 **caractérisé en ce que** la fréquence de commutation est égale à la fréquence d'échantillonnage de sortie du quantificateur (1).

6. Procédé selon la revendication 1 ou 2 **caractérisé en ce que** le signal de porteuse est non sinusoïdal d'une telle façon qu'il est une somme de composantes de fréquence, où toutes les composantes ont des fréquences qui sont des entiers de la fréquence d'échantillonnage de sortie du quantificateur.

7. Procédé selon la revendication 6 **caractérisé en ce que** les signaux de porteuse sont choisis de sorte qu'ils restent proches de zéro pour l'intervalle de temps autour des événements de commutation.

8. Procédé selon la revendication 1 ou 2 **caractérisé en ce que** le signal d'information est décalé en quadrature en deux composantes, moyen par lequel deux signaux numériques sont formés dans l'étape a) commandant les commutateurs dans deux amplificateurs/mélangeurs différents de l'invention, qui sont alimentés avec des porteuses ayant des différences de phase de 90°.

9. Procédé selon la revendication 1 ou 2 **caractérisé en ce que** les bandes latérales sont utilisées comme deux canaux linéairement indépendants comme dans l'agencement de phase en quadrature I et Q de la revendication 9.

10. Procédé selon la revendication 7 ou 8 **caractérisé en ce que** les signaux formés dans l'étape b) sont additionnés avant le filtre lorsqu'un filtre passe-bande est utilisé.

11. Procédé selon la revendication 7 ou 8 **caractérisé en ce que** les signaux sont additionnés après les filtres passe-bande lorsque deux filtres passe-bande sont utilisés.

12. Procédé selon l'une quelconque des revendications 8 à 11 **caractérisé en ce que** le/les filtre(s) est/sont (a) un/des filtre(s) passe-bande rejetant une distorsion provoquée par l'amplification.

13. Procédé selon l'une quelconque des revendications 1 à 12 **caractérisé en ce que** l'on forme un signal (S_{M}) avec deux valeurs de signal dans l'étape a).

14. Dispositif destiné à produire un signal radio fréquence modulé de forte puissance, comportant :
un quantificateur (1) destiné à former par impulsion un signal (S₁) d'information pour former un signal (S_{M}) numérique ayant des valeurs (M) de signal discrètes,
un ou plus générateurs (A_{M}) d'onde porteuse radiofréquence,
un module (2) de commutation comportant deux ou plus commutateurs (SM) pour obtenir un signal (S_{SW}) radiofréquence amplifié et commuté transportant l'information, les commutateurs étant commandés par le contenu d'information du signal numérique,
un filtre (4) destiné à obtenir le signal désiré,
**caractérisé en ce que** les commutateurs (SM) sont raccordés à leurs générateurs respectifs d'onde porteuse radiofréquence pour provoquer un mélange des signaux (S_{M}) numériques avec une onde porteuse correspondante conformément au contenu d'information du signal (S_{M}) numérique par une fermeture d'un commutateur (SM) donné à un contenu d'information donné du signal numérique, uniquement un commutateur étant fermé à la fois, les instants dans le temps pour les événements de commutation étant choisis pour coïncider avec le moment pendant lequel l'onde porteuse est nulle ou proche de zéro afin d'éviter des pertes d'énergie pendant les transitoires de commutation.

15. Dispositif selon la revendication 14, **caractérisé en ce que** le quantificateur (1) est un modulateur sigma-delta.

16. Dispositif selon la revendication 14 ou 15, **caractérisé en ce que** le filtre (4) est un filtre passe-bande rejetant des signaux ainsi qu'une distorsion non désirés provoqués par l'amplification.

17. Dispositif selon l'une quelconque des revendications 14 à 16, **caractérisé en ce que** le générateur d'onde porteuse est un transformateur (5) produisant des ondes porteuses de deux amplitudes différentes.
